Europäisches Patentamt

European Patent Office

Office européen des brevets

(11) Veröffentlichungsnummer: **0 234 487 B1**

(12) **EUROPÄISCHE PATENTSCHRIFT**

(45) Veröffentlichungstag der Patentschrift: **12.08.92**

(51) Int. Cl.⁵: **H01C 1/142**, H01C 17/28

(21) Anmeldenummer: **87102255.4**

(22) Anmeldetag: **17.02.87**

(54) **Dünnschichtschaltung und ein Verfahren zu ihrer Herstellung.**

(30) Priorität: **20.02.86 DE 3605425**

(43) Veröffentlichungstag der Anmeldung:
**02.09.87 Patentblatt 87/36**

(45) Bekanntmachung des Hinweises auf die
Patenterteilung:
**12.08.92 Patentblatt 92/33**

(84) Benannte Vertragsstaaten:
**AT BE CH DE ES FR GB GR IT LI NL SE**

(56) Entgegenhaltungen:
**EP-A- 0 016 263**
**GB-A- 2 186 597**
**US-A- 3 849 757**
**US-A- 4 077 854**

**ELECTRICAL DESIGN NEWS, 25. November 1981, Seiten 141-149, US; J. E. SERGENT: "Thin-film hybrids provide an alternative"**

**EXTENDED ABSTRACTS**

(73) Patentinhaber: **Standard Elektrik Lorenz Aktiengesellschaft**
**Lorenzstrasse 10**
**W-7000 Stuttgart 40(DE)**

(72) Erfinder: **Müller, Siegfried, Dr.**
**Pfeiferstrasse 19**
**W-7440 Nürtingen(DE)**
Erfinder: **Hanisch, Helmut**
**Am Langen Hag 15**
**W-7440 Nürtingen(DE)**

(74) Vertreter: **Pohl, Herbert, Dipl.-Ing et al**
**Standard Elektrik Lorenz AG Patent- und Lizenzwesen Postfach 30 09 29**
**W-7000 Stuttgart 30(DE)**

EP 0 234 487 B1

**Beschreibung**

Die Erfindung betrifft eine Dünnschichtschaltung mit integrierten Widerständen und Leiterbahnen nach dem Oberbegriff des Anspruchs 1 und ein Verfahren zu ihrer Herstellung.

Es ist aus der Zeitschrift Electrical Design News, USA, vom 25.Nov.1981, S. 141 ff eine Dünnschichtschaltung bekannt, bei der zur Bildung integrierter Widerstände eine strukturierte NiCr-Schicht auf einem Keramiksubstrat aufgebracht ist. Auf dieser befindet sich eine strukturierte Ni-Schicht als Diffusionssperre und eine strukturierte Au-Schicht für die Leiterzüge.

Will man auf derartigen Leiterzügen aus Gold herkömmliche Lötverbindungen mit Blei-Zinn-Lot anbringen, sollte die Schichtdicke der Leiterzüge nicht dicker als 1,5 $\mu$m sein, denn die Goldschicht wird durch das flüssige Lot teilweise gelöst und bildet mit dem Lot eine Legierung. Überschreitet der Goldanteil der Legierung einen bestimmten Schwellwert, wird die Legierung spröde. Der Goldanteil nimmt mit steigender Schichtdicke der Leiterzüge aus Gold zu. Mechanische Spannungen, die z.B. durch Temperaturänderungen hervorgerufen werden können, führen leicht zu Rissen, die von der spröden Blei-Zinn-Gold-Legierung ausgehen. Die Rißgefahr nimmt dabei mit zunehmender Schichtdicke der Leiterzüge aus Gold zu.

Wird nun an eine Dünnschichtschaltung die Anforderung gestellt, daß sie auch im GHz-Bereich anwendbar ist, können nur Leiterzüge mit einem sehr niedrigen Flächenwiderstand ($R_F \leq 10$mOhm) verwendet werden.

Da sich die Breite der Leiterzüge stark auf die Kapazität zwischen zwei benachbarten Leiterzügen auswirkt, wird die Reduzierung des Flächenwiderstands günstigerweise durch die Vergrößerung der Schichtdicke ausgeführt, wobei Schichtdicken von 6 $\mu$m bis 10 $\mu$m notwendig sind. Mit Blei-Zinn-Loten gelötete Gold-Leiterzüge dieser Schichtdicke weisen keine ausreichende mechanische Stabilität auf.

Diese Nachteile werden bei der aus Druckschrift US-A-3,849,757 bekannten Dünnschichtschaltung überwunden indem Leiterzügen auf einer Molybdän-Diffusionssperrenschicht angeordnet und geeignet ausgebildet sind. Die Leiterzüge bestehen hierzu aus einer 1 $\mu$m dicken Goldschicht, einer auf dieser aufgebrachten Molybdän-Legierungssperrenschicht und darauf zur Kontaktierung aufgebrachte Goldkuppeln. Kontakte mit Blei-Zinn-Loten können dabei auf der Legierungssperre aufgebracht werden, sogenannte Bondkontakte werden mit den Goldkuppeln verbunden. Durch die Anordnung der Goldkuppeln ist dabei fest vorgegeben, an welchen Stellen gelötet und an welchen Stellen gebondet werden kann.

Der Erfindung liegt die Aufgabe zugrunde, eine Dünnschichtschaltung zu schaffen, die im GHz-Bereich anwendbar ist und deren Leiterzüge einen Flächenwiderstand $R_F$ < 10 mOhm aufweisen, wobei die Leiterzüge an beliebiger Stelle sowohl gebondet als auch mit herkömmlichen Blei-Zinn-Loten gelötet werden können.

Diese Aufgabe wird bei einer gattungsmäßigen Schaltung durch die kennzeichnenden Merkmale des Anspruchs 1 und durch das Verfahren des Anspruchs 4 gelöst.

Ein besonderer Vorteil der Erfindung liegt darin, daß die Diffusionssperrenschicht durch Ätzen strukturiert werden kann, ohne daß die Legierungssperrenschicht nachteilig beeinflußt wird.

Weitere Ausgestaltungen der Erfindung sind den übrigen Ansprüchen zu entnehmen.

Ein Ausführungsbeispiel der Erfindung und ein Verfahren zur Herstellung der Erfindung werden im folgenden anhand der Figuren 1 bis 3 näher beschrieben. Es zeigen:

Fig.1    ein Ausführungsbeispiel für den Schichtaufbau einer erfindungsgemäßen Dünnschichtschaltung, perspektivisch dargestellt,

Fig.2    das Ausführungsbeispiel gemäß Fig. 1 vor dem Aufbringen der Leiterzüge, und

Fig.3    das Ausführungsbeispiel gemäß Fig. 1 vor dem Strukturieren der Widerstandsschicht.

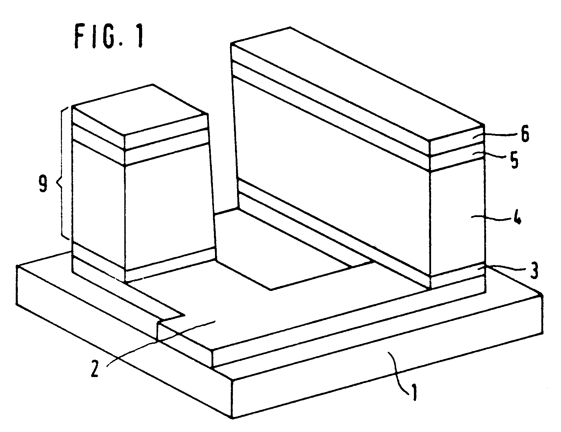

Das Ausführungsbeispiel betrifft die Schichtstruktur einer erfindungsgemäßen Dünnschichtschaltung. Es wird in Fig. 1 ein Ausschnitt einer Dünnschichtschaltung aufgezeigt, der repräsentativ Leiterzüge und Widerstände beinhaltet. Eine vollständige Dünnschichtschaltung ist aus solchen Leiterzügen und Widerständen aufgebaut und entsprechend den Bedürfnissen strukturiert. Bondkontakte oder Lötstellen werden auf der obersten Schicht der Leiterzüge angebracht.

Der Aufbau der erfindungsgemäßen Dünnschichtschaltung ist in Fig.1 perspektivisch dargestellt. Auf einem $Al_2O_3$-Substrat 1 befindet sich eine strukturierte NiCr-Schicht 2, welche die integrierten Widerstände mit einem Flächenwiderstand von z.B. $R_F$ = 100 Ohm bildet. Die Schichtdicke der NiCr-Schicht 2 liegt dabei je nach späterer Verwendung der Dünnschichtschaltung im Bereich von 30 nm bis 50 nm und die Schichtbreite im Bereich von 50 $\mu$m bis 100 $\mu$m. Auf den Oberflächenbereichen der NiCr-Schicht 2, die sich mit den Leiterzügen überschneiden, ist eine Ni-Schicht 3 mit einer Schichtdicke d = 0,3 $\mu$m als Diffusionssperre angebracht. Darauf befindet sich die untere Au-Schicht 4 mit einer Schichtdicke 2 $\mu$m $\leq$ d $\leq$ 10$\mu$m. Als Legierungssperre befindet sich auf der unteren Au-Schicht 4 eine Pd-Schicht 5. Auf dieser ist die obere Au-Schicht 6 angebracht. Die Pd-Schicht 5 und die obere Au-Schicht 6 weisen je eine Schichtdicke d = 1 $\mu$m auf. Die untere Au-Schicht 4, die Pd-Schicht 5 und die obere Au-Schicht 6 bilden die Leiterzüge 9.

Der Flächenwiderstand der Leiterzüge 9 beträgt R $\leq$ 10 mOhm und wird bei vorgegebener Schichtbreite der Leiterzüge 9 durch die Schichtdicke der unteren Au-Schicht 4 variiert. Die Diffusionssperre verhindert das Eindringen von Au-Atomen aus der unteren Au-Schicht 4 in die NiCr-Schicht 2 und verhindert somit die Änderung des elektrischen Widerstandes der NiCr-Schicht 2. Die Legierungssperre ermöglicht, daß die Leiterzüge 9 mit herkömmlichem Blei-Zinn-Lot gelötet werden können, ohne daß sich eine spröde Legierung bildet. Die Dicke der oberen Goldschicht ist so bemessen, daß sich beim Löten mit üblichem Blei-Zinn-Loten keine spröde Legierung bilden kann. Das Vorhandensein der oberen Au-Schicht 6 ist notwendig, wenn die Leiterzüge nicht nur lötbar, sondern auch bondbar sein sollen.

Eine Pt-Schicht als Legierungssperre verursacht aufgrund des hohen Materialpreises hohe Kosten. Eine Ni-Schicht als Legierungssperre wird während des Herstellungsverfahrens chemisch angegriffen und dabei unterätzt, was eine mechanische Schwächung der Leiterzüge 9 zur Folge hat. Anstelle des $Al_2O_3$-Substrats 1 sind auch andere gebräuchliche Substrate wie z. B. Glassubstrate anwendbar. Als Werkstoff für die Widerstandsschicht kann auch Tantalnitrid in der Form $Ta_2N$ oder TaN aufgebracht sein.

Ein Verfahren zur Herstellung der erfindungsgemäßen Dünnschichtschaltung wird im folgenden beschrieben:

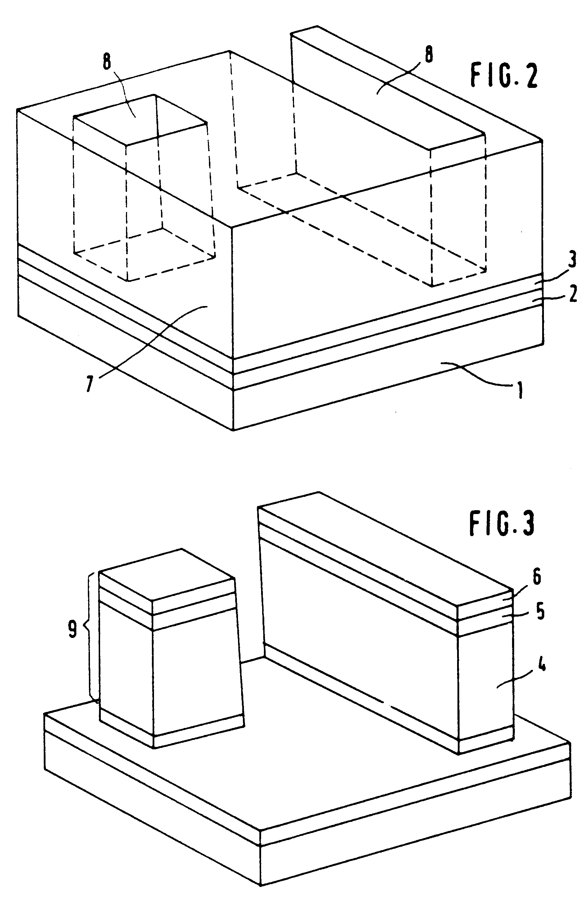

Auf das $Al_2O_3$-Substrat 1 wird eine NiCr-Schicht 2 ganzflächig aufgedampft oder gestäubt. Darauf wird eine Ni-Schicht 3 ebenfalls ganzflächig aufgedampft oder gestäubt. Im nächsten Verfahrensschritt wird eine Lackmaske 7 aufgebracht (Fig. 2), die Freiräume 8 an den Stellen aufweist, an denen die Leiterzüge 9 angebracht werden sollen. Die Schichtdicke d der Lackmaske beträgt je nach gewünschter Schichtdicke der unteren Au-Schicht 4 $\mu$m $\leq$ d $\leq$ 12 $\mu$m. Die Lackmaske 7 wird, wenn notwendig in mehreren Schichten aufgetragen. Anschließend wird zuerst die untere Au-Schicht 4, dann die Pd-Schicht 5 und zuletzt die obere Au-Schicht 6 galvanisch abgeschieden. Danach erfolgt das Entfernen der Lackmaske 7 und das Abätzen der Ni-Schicht 3, soweit sie nicht unter den Leiterzügen 9 liegt. Das Ausführungsbeispiel ist für diese Verfahrensstufe in Fig. 3 abgebildet. Abschließend wird die NiCr-Schicht photolithographisch strukturiert, wodurch die integrierten Widerstände festgelegt (Fig.1) werden.

Aus der Verfahrensbeschreibung wird der Vorteil einer Pd-Schicht 5 als Legierungssperre gegenüber einer Ni-Schicht deutlich, denn beim Abätzen der aufgedampften oder gestäubten Ni-Schicht 3 würde eine Legierungssperre aus Ni zum Teil abgetragen werden.

**Patentansprüche**

1. Dünnschichtschaltung mit mehrschichtigen, zum Teil aus Goldschichten bestehenden Leiterzügen (9),
   **dadurch gekennzeichnet,** daß die Leiterzüge (9) auf einer als Nickelschicht ausgebildeten Diffusionssperrenschicht (3) angeordnet sind, eine untere Goldschicht (4), eine obere Goldschicht (6) und eine dazwischenliegende als Palladium-Schicht ausgebildete Legierungssperrenschicht (5) aufweisen.

2. Dünnschichtschaltung nach Anspruch 1, dadurch gekennzeichnet, daß die Dicke der unteren Goldschicht (4) wenigstens 2 $\mu$m beträgt.

3. Dünnschichtschaltlung nach Anspruch 1 oder 2, dadurch gekennzeichnet,
   - daß sie zusätzlich integrierte Widerstände als strukturierte Widerstandsschicht (2) aufweist,
   - daß die Diffusionssperrenschicht (3) in den Bereichen zwischen der strukturierten Widerstandsschicht (2) und den Leiterzügen (9) angeordnet ist,
   - daß das Substrat (1) aus $Al_2O_3$ und die Widerstandsschicht (2) aus einer Nickel-Chrom-Legierung besteht, und
   - daß die untere Goldschicht (4) eine Dicke zwischen 2 $\mu$m und 10 $\mu$m, die Legierungssperrenschicht (5) eine Dicke zwischen 0,3 $\mu$m und 1 $\mu$m und die obere Goldschicht (5) eine Dicke zwischen 0,5 $\mu$m und 1,5 $\mu$m aufweisen.

4. Verfahren zur Herstellung einer Dünnschichtschaltung mit auf einer als Nickel-Schicht ausgebildeten Diffusionssperrenschicht (3) befindlichen, mehrschichtigen, zum Teil aus Goldschichten (4, 6) bestehenden Leiterzügen (9),
   **dadurch gekennzeichnet,** daß zum Aufbringen der Leiterzüge (9) folgende Verfahrensschritte durchgeführt werden:
   a) Aufbringen einer Lackmaske (7) zur Strukturierung der noch aufzubringenden Leiterzüge (9),
   b) galvanisches Abscheiden einer unteren Goldschicht (4),
   c) galvanisches Abscheiden einer Palladium-Schicht als Legierungssperrenschicht (5),

d) galvanisches Abscheiden einer oberen Goldschicht (6) und

e) entfernen der Lackmaske (7).

5. Verfahren zur Herstellung einer Dünnschichtschaltung nach Anspruch 4, dadurch gekennzeichnet,

- daß die Widerstandsschicht (2) und die Diffusionssperrenschicht (3) aufgedampft oder aufgestäubt werden,
- daß nach Entfernen der Lackmaske (7) der freiliegende Bereich der Diffusionssperrenschicht (3) entfernt wird, und
- daß die Widerstandsschicht (2) im freiliegenden Bereich fotolithographisch strukturiert wird.

## Claims

1. A thin-film circuit with multilayer conductors (9) formed partly by gold layers, **characterized in** that the conductors (9) are arranged on a diffusion barrier layer (3) of nickel and consist of a lower gold layer (4), an upper gold layer (6), and an intermediate alloying barrier layer (5) of palladium.

2. A thin-film circuit as claimed in claim 1, characterized in that the thickness of the lower gold layer (4) is at least 2 $\mu$m.

3. A thin-film circuit as claimed in claim 1 or 2, characterized in
   - that it further includes integrated resistors in the form of a resistive layer (2),
   - that the diffusion barrier layer (3) is located in the areas between the patterned resistive layer (2) and the conductors (9),
   - that the substrate (1) is of $Al_2O_3$, and the resistive layer (2) of a nickel-chromium alloy, and
   - that the lower gold layer (4) has a thickness between 2 $\mu$m and 10 $\mu$m, the alloying barrier layer (5) a thickness between 0.3 $\mu$m and 1 $\mu$m, and the upper gold layer (6) a thickness between 0.5 $\mu$m and 1.5 $\mu$m.

4. A method of making a thin-film circuit with multi-layer conductors (9) arranged on a diffusion barrier layer (3) of nickel and formed partly by gold layers (4, 6), **characterized in** that the following steps are performed to deposit the conductors (9):
   a) applying a photoresist mask (7) for delineating the conductors (9) to be deposited;
   b) electrodepositing a lower gold layer (4);
   c) electrodepositing a palladium layer as an alloying barrier layer (5);

d) electrodepositing an upper gold layer (6), and

e) removing the photoresist mask (7).

5. A method of making a thin-film circuit as claimed in claim 4, characterized in
   - that the resistive layer (2) and the diffusion barrier layer (3) are deposited by evaporation or sputtering,
   - that after removal of the photoresist mask (7), the exposed portion of the diffusion barrier layer (3) is removed, and
   - that the resistive layer (2) is patterned in the exposed area by photolithographic techniques.

## Revendications

1. Circuit à couche mince à bandes conductrices (9) multi-couches composées partiellement de couches d'or, caractérisé en ce que les bandes conductrices (9) sont disposées sur une couche (3) de barrière de diffusion constituée d'une couche de nickel, et comportent une couche inférieure (4) en or, une couche supérieure (6) en or et une couche de barrière d'alliage (5) sous forme d'une couche de palladium disposée entre ces deux dernières couches.

2. Circuit à couche mince selon la revendication 1, caractérisé en ce que l'épaisseur de la couche inférieure (4) en or est d'au moins 2 $\mu$m.

3. Circuit à couche mince selon la revendication 1 ou 2, caractérisé en ce que:
   - il comporte en plus des résistances intégrées sous forme d'une couche de résistance (2) structurée;
   - la couche (3) de barrière de diffusion est disposée dans la région comprise entre la couche de résistance (2) structurée et les bandes conductrices (9);
   - le substrat (1) est composé d'$Al_2O_3$ et la couche de résistance (2) d'un alliage nickel-chrome; et
   - la couche inférieure (4) en or a une épaisseur comprise entre 2 $\mu$m et 10 $\mu$m, la couche (5) de barrière d'alliage a une épaisseur comprise entre 0,3 $\mu$m et 1 $\mu$m et la couche supérieure (5) en or a une épaisseur comprise entre 0,5 $\mu$m et 1,5 $\mu$m.

4. Procédé de fabrication d'un circuit à couche mince à bandes conductrices (9) multi-couches composées partiellement de couches d'or (4, 6) et disposées sur une couche de barrière de diffusion (3) elle-même composée d'une couche de nickel, caractérisé en ce qu'il comporte, pour l'application des bandes conductrices (9), les étapes suivantes:

    (a) application d'un masque (7) en vernis afin de structurer les bandes conductrices (9) qui doivent être appliquer;

    (b) dépôt galvanique d'une couche inférieure en or (4);

    (c) dépôt galvanique d'une couche de palladium en tant que couche de barrière d'alliage (5);

    (d) dépôt galvanique d'une couche supérieure (6) en or; et

    (e) élimination du masque (7) en vernis.

5. Procédé de fabrication d'un circuit à couche mince selon la revendication 4, caractérisé en ce que:

    - la couche de résistances (2) et la couche de barrière de diffusion (3) sont déposées par évaporation sous vide ou pulvérisation cathodique;

    - après l'élimination du masque (7) en vernis, la zone exposée de la couche de barrière de diffusion (3) est éliminée; et

    - la couche de résistance (2) est structurée photolithographiquement dans la zone exposée.

FIG. 1

FIG.2

8

8

3

2

7

1

FIG.3

6

5

4

9